# EUROPEAN PATENT SPECIFICATION

(11) **EP 1 793 267 B1**
(45) Date of publication and mention of the grant of the patent: **21.03.2012**
(21) Application number: 05111662.2
(22) Date of filing: 02.12.2005
(51) Int. Cl.: G02F 1/1362, H01L 27/12, H01L 21/84

(54) **Stacked storage capacitor structure for a LTPS TFT-LCD**
Stapelkondensatorstruktur für ein LTPS TFT-LCD
Structure à condensateur empilé pour un LTPS TFT-LCD

(43) Date of publication of application: 06.06.2007
(73) Proprietor: Chimei InnoLux Corporation, Chu-Nan 350 Miao li 350 (TW)
(72) Inventor: Lee, Mu-Chia, 104,, Taipei City (TW); Chang, Wei-Chih, 350, Miaoli County (TW); Huang, Chun-Wei, 235,, Taipei County (TW); Lu, Hung-Che, 300, Hsinchu City (TW); Kuo, Kuo-Hung, 806, Kaohsiung City (TW); Li, Hong-Bin, 303, Hsinchu County (TW); Lai, Wen-Guei, 520, Changhua Conty (TW); Tsai, Chia-Yi, 265, Yilan County (TW); Chang, Yu-Chi, 265, Hsinchu County (TW); Li, Hau-Chiun, 950, Taitung County (TW)
(74) Representative: 2K Patentanwälte Blasberg Kewitz & Reichel

(56) References cited:
- EP-A- 0 066 852
- EP-A- 0 464 579
- EP-A1- 0 668 528
- US-A- 5 831 692

## Description

### BACKGROUND

The invention relates to a low temperature polysilicon (LTPS) TFT-LCD, and more particularly to a stacked storage capacitor structure and methods for fabricating the same.

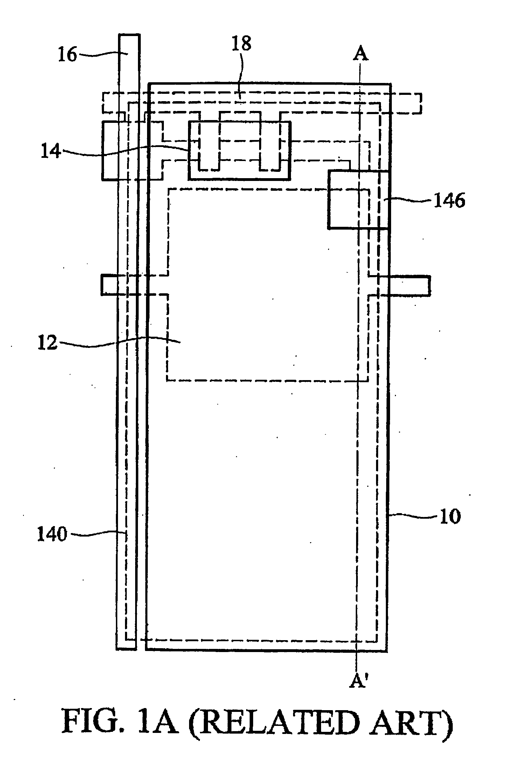

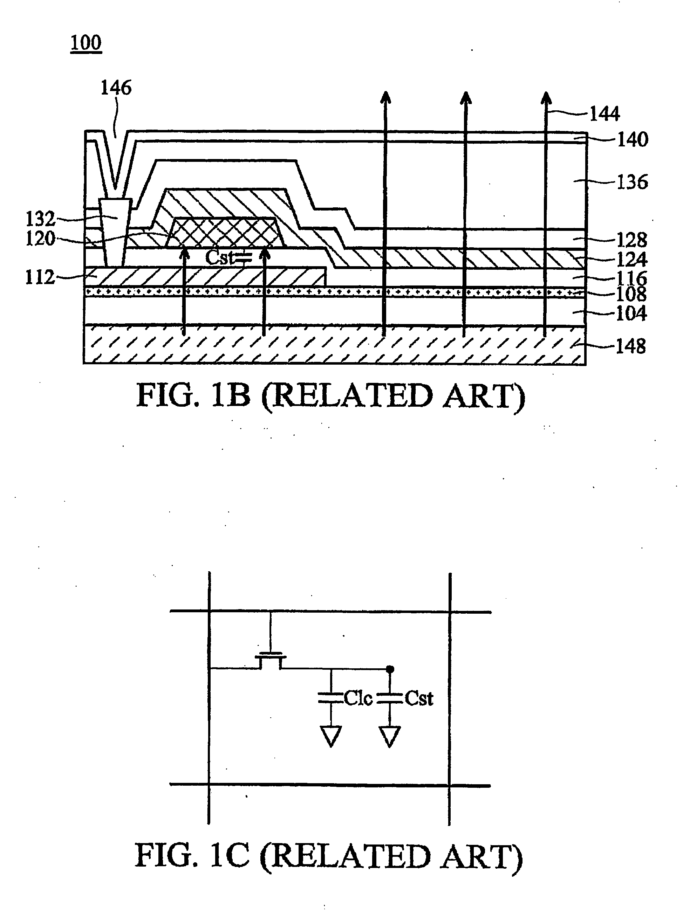

Fig. 1A is a plan view of a pixel in which a storage capacitor for a conventional LTPS TFT-LCD is formed. Fig. 1B is a sectional view taken along line A-A' of the pixel shown in Fig. 1A. Fig. 1C is an equivalent circuit of the pixel shown in Fig. 1A.

In Fig. 1A, a pixel 10 with a storage capacitor 12, a TFT 14 and a pixel electrode 140 disposed thereon is provided. A signal line 16 and a gate line 18 cross in the vicinity of the TFT 14, and are disposed around the pixel 10. The pixel electrode 140 and the storage capacitor 12 are electrically connected to the TFT 14 by means of via 146.

In Fig. 1B, a processed substrate 104 comprising a buffer layer 108, a p-Si layer 112 as a first conductive layer, a gate insulating layer 116, a second conductive layer 120, a first interlayer dielectric 124, and a second interlayer dielectric 128 is provided. The p-Si layer 112, the second conductive layer 120 and the gate insulating layer 116 therebetween consist of the storage capacitor (Cst)12. By means of well known processes, a metal layer 132 is formed. Thereafter, a passivation layer 136 with via 146 therein is formed over the metal layer 132 and the second interlayer dielectric 128. A transparent pixel electrode 140 is conformally formed over the passivation layer 136 and the via 146. The pixel electrode 140 may comprise ITO or IZO. Additionally, a backlight module 148 is disposed on the other side of the substrate 104, thus, a TFT array substrate 100 for a LTPS TFT-LCD is obtained. The arrow 144 represents light from the backlight module 148.

In Fig. 1C, an equivalent circuit of the pixel shown in Fig. 1A is provided.

To meet the increased requirements the higher display resolution, pixel size must be decreased, thus, the area of the storage capacitor used in LTPS TFT-LCDs must be minimized concurrently. As the display resolution increases, however, the area available on each pixel for the storage capacitor must be reduced to maintain aperture ratio. At the same time, problems such as flickering, image retention and cross-talk are likely to occur.

EP 0 464 579 A2 discloses thin film field effect transistor array comprising a plurality of parallel gate bus lines formed on a transparent insulative substrate, and a plurality of parallel drain bus lines formed on the transparent insulative substrate so as to intersect the gate bus lines. A plurality of pixel electrodes are each formed in proximity of a corresponding one of intersections between the gate bus lines and the drain bus lines, and a plurality of thin film field effect transistors are each formed in proximity of a corresponding one of intersections between the gate bus lines and the drain bus lines. Each of the thin film field effect transistors is connected to a corresponding one of the pixel electrodes. A plurality of storage capacitors are each formed in proximity of and connected in parallel to a corresponding one of the pixel electrodes. Each of the storage capacitors is formed of a stacked structure having at least first, second and third level capacitor electrodes which are stacked in the named order and separated from each other by an intervening insulating layer. At least one of the first, second and third level capacitor electrodes is connected to a corresponding one of the gate bus lines.

US 5,831,692 discloses a liquid crystal display including a first conductive layer on a substrate, and a first insulating layer on the first conductive layer. The first insulating layer includes a first contact hole therein exposing a portion of the first conductive layer. A second conductive layer is provided on the first insulating layer opposite the first conductive layer and adjacent the first contact hole, and a second insulating layer is provided on the second conductive layer. A third conductive layer is provided on a first portion of the second insulating layer opposite the second conductive layer and adjacent the first contact hole, and the third conductive layer extends through the first contact hole contacting the first conductive layer. A third insulating layer is provided on a second portion of the second insulating layer adjacent the first portion and opposite the second conductive layer, and a data line is provided on the third insulating layer opposite the second insulating layer and the second conductive layer. A protective layer covers the third conductive layer, the third insulating layer, and the data line, and the protective layer includes a second contact hole which exposes a portion of the third conductive layer. A pixel electrode on the protective layer extends through the second contact hole contacting the third conductive layer.

EP 0 668 528 At discloses a thin film field effect transistor array including a stacked storage capacitor according to the preamble of claim 1. The array comprises a plurality of parallel gate bus lines formed on a transparent insulative substrate, and a plurality of parallel drain bus lines formed on the transparent insulative substrate so as to intersect the gale bus lines. A plurality of pixel electrodes are each formed in proximity of a corresponding one of intersections between the gate bus lines and the drain bus lines, and a plurality of thin film field effect transistors are each formed in proximity of a corresponding one of intersections between the gate bus lines and the drain bus lines. Each of the thin film field effect transistor is connected to a corresponding one of the pixel electrodes. A plurality of storage capacitors are each formed in proximity of and connected in parallel to a corresponding one of the pixel electrodes. Each of the storage capacitors is formed of a stacked structure having at least first, second and third level capacitor electrodes which are stacked In the named order and separated from each other by an intervening insulating layer. At least one of the first, second and third level capacitor electrodes is connected to a corresponding one of the gate bus lines.

### SUMMARY OF INVENTION

It is an object of the present invention to provide an enhanced stacked storage capacitor structure for an LTPS TFT-LCD capable of increasing storage capacitance without sacrificing the aperture ratio of a pixel, or maintaining the storage capacitance while increasing the aperture ratio of a pixel in an LTPS TFT-LCD is desirable. According to further aspects of the present invention there are to be provided an LTPS TFT-LCD including such a stacked storage capacitor structure and an electronic device including such an LTPS TFT-LCD.

The above problems are solved by an LTPS TFT-LCD according to claim 1, by an LTPS TFT-LCD according to claim 9 and by an electronic device according to claim 10. Further advantageous embodiments are the subject-matter of the dependent claims.

The invention discloses a stacked storage capacitor structure for LTPS TFT-LCDs. A first embodiment of the invention comprises a processed substrate, a first storage capacitor and a second storage capacitor. The first storage capacitor comprises a first conductive layer, a second conductive layer and a first insulating layer therebetween, wherein the second conductive layer is disposed over the first conductive layer, and the first storage capacitor is disposed over the processed substrate. The stacked storage capacitor structure further comprises a third conductive layer including a first portion and an extended second portion. The second storage capacitor comprises the second conductive layer, the extended second portion of the third conductive layer and a second insulating layer therebetween, wherein the extended second portion of the third conductive layer is disposed over the second conductive layer, and wherein the second storage capacitor is on the first storage capacitor, and is electrically connected thereto.

The first embodiment further comprises a passivation layer with via therein and a pixel electrode overlying the passivation layer, wherein the pixel electrode is electrically connected to the first portion of the third conductive layer through the via. In addition, the embodiment further comprises a third insulating layer between the second insulating layer and the extended second portion of the third conductive layer, wherein the third insulating layer and the second insulating layer has a recessed portion.

Preferably, in a second embodiment further comprises a third insulating layer is disposed between the second conductive layer and the extended second portion of the third conductive layer, wherein the second insulating layer has a recessed portion at which a third portion of the second conductive layer is directly covered by the third insulating layer.

According to the embodiments of the invention, the extended portion of the third insulating layer is employed to construct the second storage capacitor overlying the first storage capacitor without occupying additional pixel area, thus, the storage capacitance is increased without affecting the aperture ratio. Specifically, the first portion and the extended portion of the third insulating layer are formed concurrently, thus, reducing the process complexity and cost.

### DESCRIPTION OF THE DRAWINGS

The invention can be more fully understood by reading the subsequent detailed description in conjunction with the examples and references made to the accompanying drawings.
Fig. 1A is a plan view of a pixel where a storage capacitor for a conventional LTPS TFT-LCD is formed.
Fig. 1B is a sectional view taken along line A-A' of the pixel shown in Fig. 1A.
Fig. 1C is an equivalent circuit of the pixel shown in Fig. 1A.
Fig. 2A is a plan view of a pixel where a stacked storage capacitor structure for a LTPS TFT-LCD of a first embodiment of the invention is formed.
Fig. 2E is a sectional view taken along line B-B' of the pixel shown in Fig. 1A, and Figs. 2B to 2E are sectional views of a method for fabricating the stacked storage capacitor structure.
Fig. 2F is an equivalent circuit of the pixel shown in Fig. 2A.
Fig. 2G is a sectional view of an LTPS TFT-LCD panel.
Fig. 3A is a plan view of a pixel where a stacked storage capacitor structure for a LTPS TFT-LCD of a second embodiment of the invention is formed.
Fig. 3G is a sectional view taken along line C-C' of the pixel shown in Fig. 3A, and Figs. 3B to 3G are sectional views of a method for fabricating the stacked storage capacitor structure.
Fig. 3H is a sectional view of an LTPS TFT-LCD panel.
FIG. 4 is a schematic diagram of an LTPS TFT-LCD device in accordance with the present invention.
FIG. 5 is a schematic diagram of an electronic device incorporating the LTPS TFT-LCD device shown in FIG. 4.

### DETAILED DESCRIPTION

### FIRST EMBODIMENT

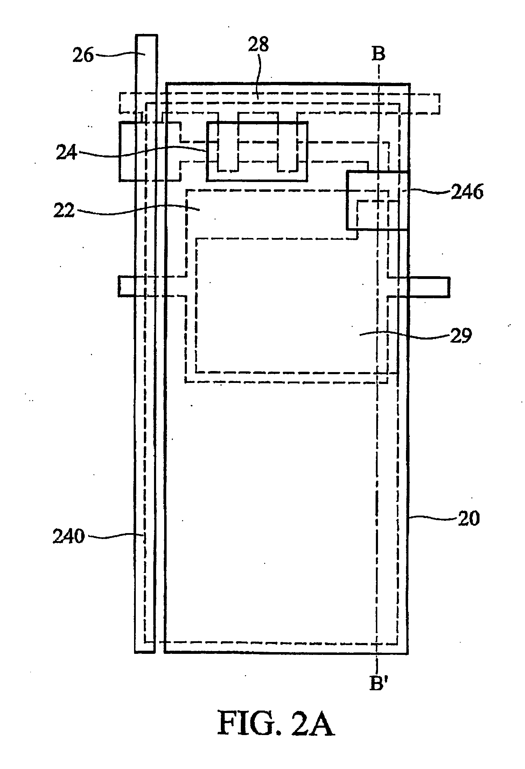

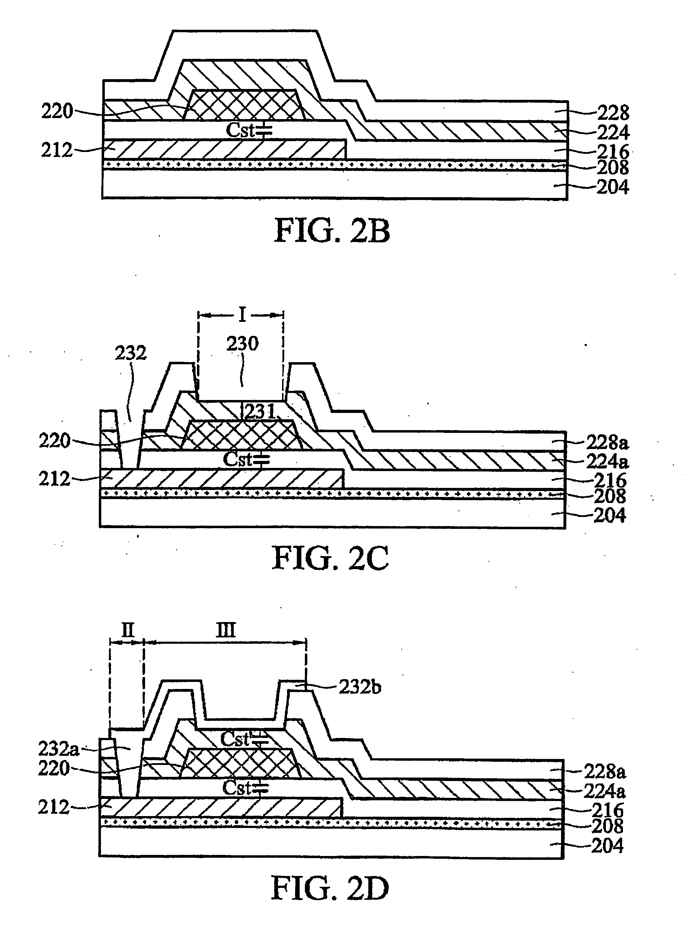

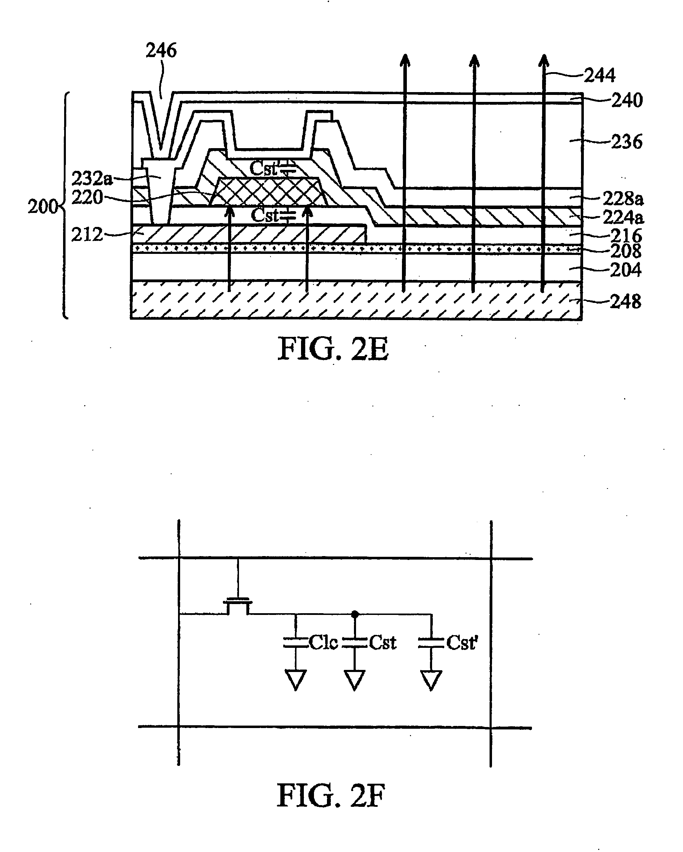

Fig. 2A is a plan view of a pixel where a stacked storage capacitor structure for a TFT structure of an embodiment of the invention is formed. Fig. 2E is a sectional view taken along line B-B' of the pixel shown in Fig. 2A, and Figs. 2B to 2E are sectional views of a method for fabricating the TFT structure. Fig. 2F is an equivalent circuit of the pixel shown in Fig. 2A.

In Fig. 2A, a pixel 20 with a stacked storage capacitor structure comprising a first storage capacitor (Cst) 22 and a second capacitor (Cst') 29, a TFT 24 and a pixel electrode 240 disposed thereon is provided. A signal line 26 and a gate line 28 intersect in the vicinity of the TFT 24, and are disposed around the pixel 20. The second storage capacitor (Cst') 29 is over the first capacitor (Cst) 22. The pixel electrode 240 and the stacked storage capacitor structure are electrically connected to the TFT 24 by means of via 246.

In Fig. 2B, there a substrate 204, a buffer layer 208, a p-Si layer 212 as a first conductive layer, a gate insulating layer 216, a second conductive layer 220, a first interlayer dielectric 224, and a second interlayer dielectric 228 are provided. The p-Si layer 212, the second conductive layer 220 and the gate insulating layer 216 therebetween consist of the first storage capacitor (Cst) 22.

In Fig. 2C, openings 230 and 232 are formed by photolithography and etching in sequence. That is, a photoresist pattern (not shown) is formed on the second interlayer dielectric 228. A portion of the second interlayer dielectric 228 within the region I is fully etched and a portion of the first interlayer dielectric 224 within the region I is partially etched by wet etching or dry etching using the photoresist pattern as the etching mask, thus, the resultant second interlayer dielectric 228a and first interlayer dielectric 224a is formed. The first interlayer dielectric 224a and the second interlayer dielectric 2 28a have a thickness between 800 and 3000Å, preferably 3000 Å, except that the preferred thickness 231 of the first interlayer dielectric 224a within the region I is 1000 Å. The first interlayer dielectric may comprise SiNₓ or SiOₓ.

In Fig. 2D, a third conductive layer, comprising a first portion 232a and an extended second portion 232b extending over a portion of the second interlayer dielectric 228a, is deposited by conventional CVD, ECP or PVD. The first portion 232a and the extended second portion 232b are confined within regions II and III, respectively. The opening 232 is filled with a metal material comprising Al or Cu. The third conductive layer, the second conductive layer 220 and the sandwiched first interlayer dielectric 224a consist of the second storage capacitor (Cst') 29.

In Fig. 2E, by means of well known processes, a passivation layer 236 with via 246 therein is formed over the third conductive layer and the second interlayer dielectric 228a. A transparent pixel electrode 240 is conformally formed on the passivation layer 236 and the via 246. The pixel electrode 240 may comprise ITO or IZO. In addition, a backlight module 248 is disposed on the other side of the substrate 204, thus, a TFT array substrate 200 for a LTPS TFT-LCD is obtained. The arrow 244 represents light from the backlight module 248.

In Fig. 2F, as a result of the described method, a stacked storage capacitor structure comprising the first capacitor storage (Cst) 22 and the second capacitor storage (Cst') 29 has additional capacitance i.e. capacitance of the second capacitor (Cst') 29 compared to the related art.

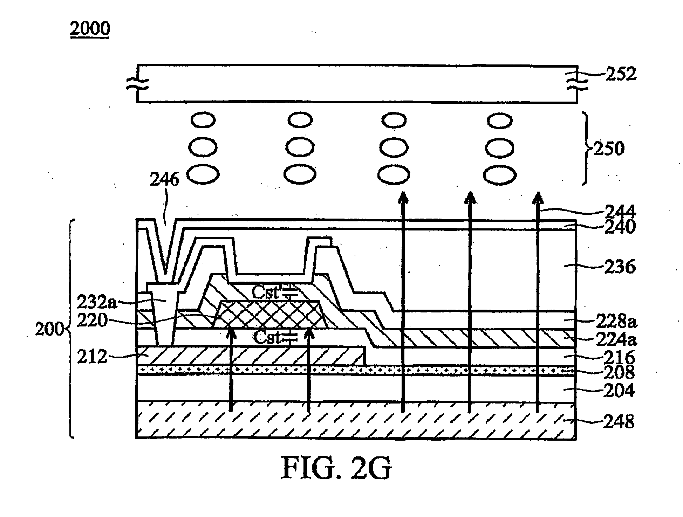

In Fig. 2 G, an LTPS TFT-LCD panel 2000 is obtained by means of attachment of the TFT array substrate 200 to a color filter substrate 252 and formation of a liquid crystal layer 250 therebetween.

### SECOND EMBODIMENT

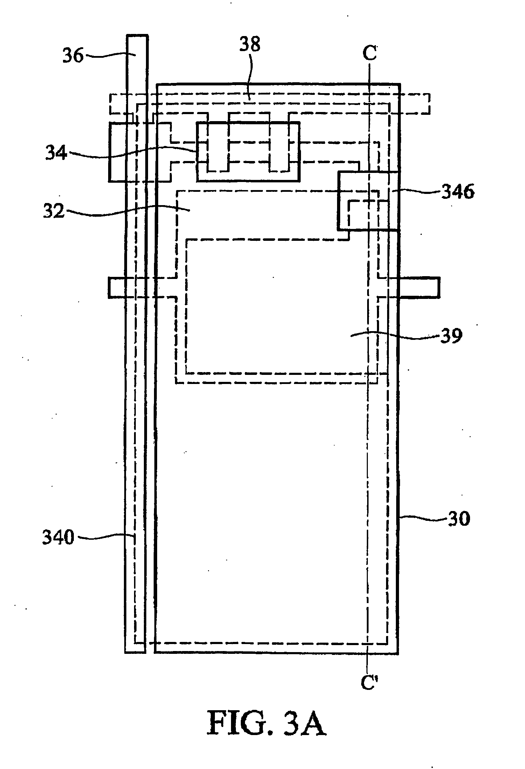

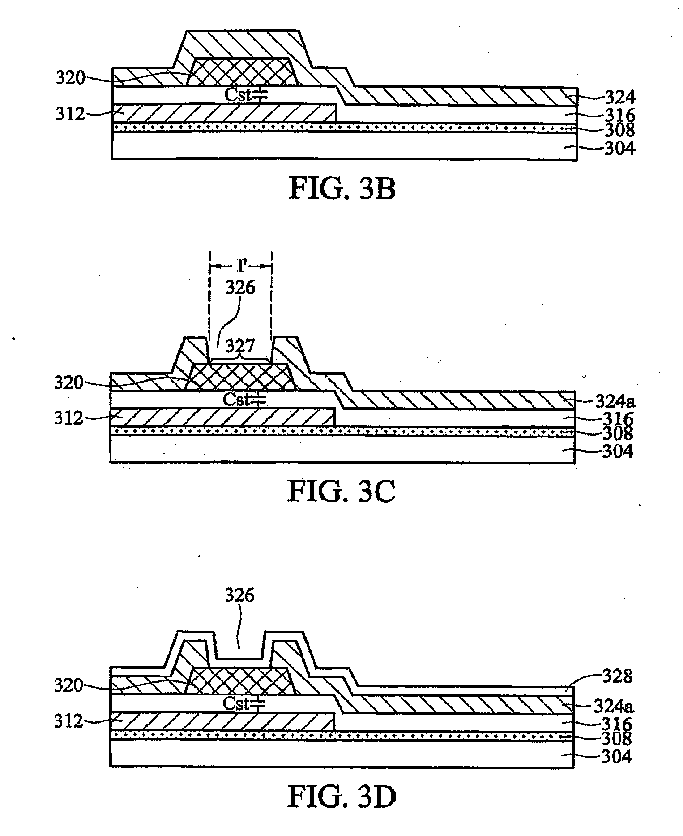

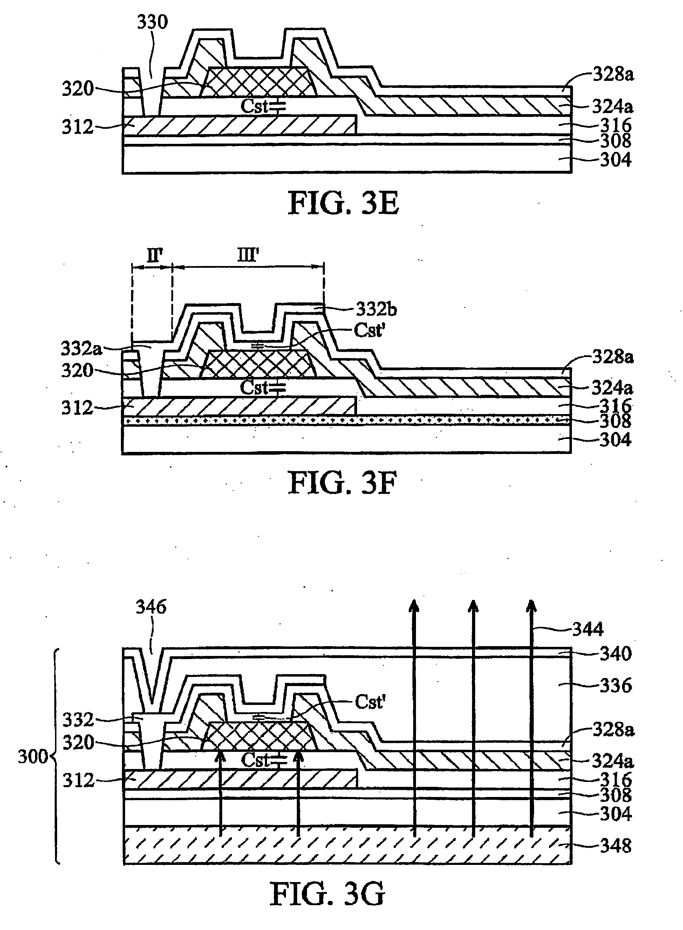

Fig. 3A is a plan view of a pixel where a stacked storage capacitor structure for a LTPS TFT-LCD of a second embodiment of the invention is formed. Fig. 3G is a sectional view taken along line C-C' of the pixel shown in Fig. 3A, and Figs. 3B to 3G are sectional views of a method for fabricating the stacked storage capacitor structure.

In Fig. 3A, a pixel 30 with a stacked storage capacitor structure comprising a first storage capacitor (Cst) 32 and a second storage capacitor (Cst') 39, a TFT 34 and a pixel electrode 340 disposed thereon is provided. A signal line 36 and a gate line 38 intersect in the vicinity of the TFT 34, and are disposed around the pixel 30. The second storage capacitor (Cst') 39 is over the first storage capacitor (Cst) 32. The pixel electrode 340 and the stacked storage capacitor structure are electrically connected to the TFT 34 by means of via 346.

In Fig. 3B, there a substrate 304, a buffer layer 308, a p-Si layer 312 as a first conductive layer, a gate insulating layer 316, a second conductive layer 320, and a first interlayer dielectric 324 is provided. The p-Si layer 312, the second conductive layer 320 and the gate insulating layer 316 therebetween consist of the first storage capacitor (Cst) 32.

In Fig. 3C, an opening 326 is formed by photolithography and etching in sequence. That is, a photoresist pattern (not shown) is formed on the first interlayer dielectric 324 which is etched by wet etching or dry etching using the photoresist pattern as the etching mask, thus, the resultant first interlayer dielectric 324a is formed. Specifically, a portion of the the first interlayer dielectric 324 within the region I' is fully removed so that a portion surface 327 of the second conductive layer 320 is exposed.

In Fig. 3D, a second interlayer dielectric 328 is conformally disposed over the first interlayer dielectric 324a and the exposed surface 327 of the second conductive layer 320. Formation of the second interlayer dielectric 328 comprises CVD or PECVD. The second interlayer dielectric 328, comprising SiNₓ or SiOₓ, has a thickness between 400 and 1200Å, preferably between 600 and 700Å.

In Fig. 3E, an opening 330 is formed by wet or dry etching through the second interlayer dielectric 328, the first interlayer dielectric 324a and the gate insulating layer 316 until a portion surface of the p-Si layer 312 is exposed while the second interlayer dielectric 328a, the first interlayer dielectric 324a and the gate insulating layer 316a remain.

In Fig. 3F, a third conductive layer, comprising a first portion 332a and an extended second portion 332b extending over a portion of the second interlayer dielectric 328a, is deposited by conventional CVD, ECP or PVD. The first portion 332a and the extended second portion 332b are confined within regions II and III, respectively. The opening 330 is filled with a metal material comprising Al or Cu. The third conductive layer, the second conductive layer and the sandwiched second interlayer dielectric 328a consist of the second storage capacitor (Cst') 39.

In Fig. 3G, by means of well known processes, a passivation layer 336 with via 346 therein is formed over the third conductive layer and the second interlayer dielectric 328a. A transparent pixel electrode 340 is conformally formed on the passivation layer 336 and the via 346. The pixel electrode 340 may comprise ITO or IZO. In addition, a backlight module 348 is disposed on the other side of the substrate 304, thus, a TFT array substrate 300 for a LTPS TFT-LCD is obtained. The arrow 344 represents light from the backlight module 348.

Similar to Fig. 2F, as a result of the described method, a stacked storage capacitor structure comprising the first storage capacitor (Cst) 32 and the second storage capacitor (Cst') 39 having additional storage capacitance i.e. capacitance of the second storage capacitor (Cst') 39 compared to the related art is formed.

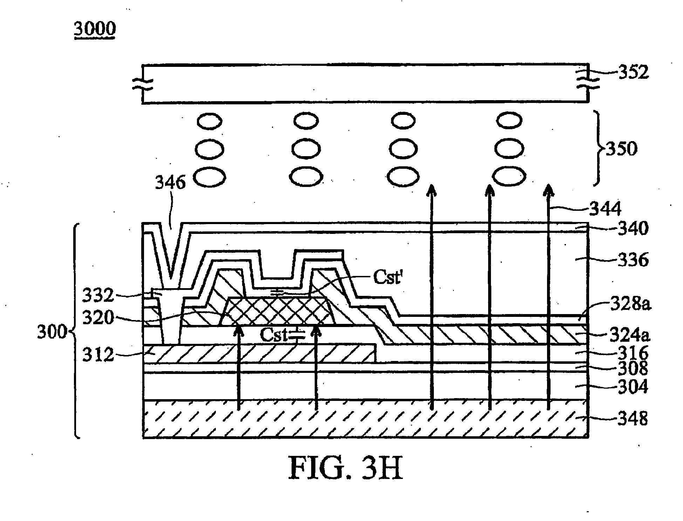

In Fig. 3H, an LTPS TFT-LCD panel 3000 is obtained by means of attachment of the TFT array substrate 300 to a color filter substrate 352 and formation of a liquid crystal layer 350 therebetween.

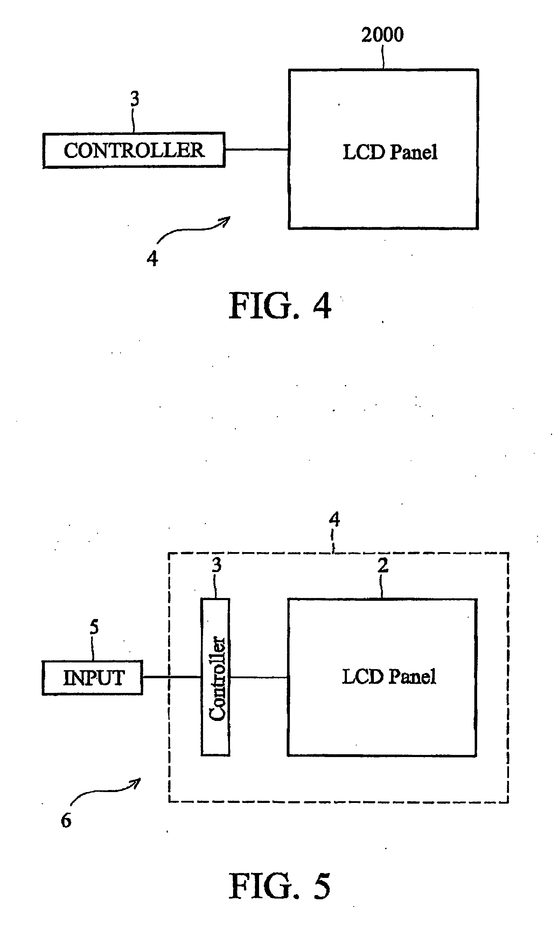

FIG. 4 is a schematic diagram illustrating an LTPS LCD device incorporating the LTPS TFT-LCD panel 2000 of FIG. 2G according to the present invention. The LTPS TFT-LCD panel 2000 as shown in FIG. 2G is coupled to a controller 3 to form a LTPS TFT-LCD device 4. The controller 3 can comprise a source and gate driving circuits (not shown) to control the LTPS TFT-LCD panel 2000 in accordance with input. In another embodiment, the LTPS TFT-LCD panel 2000 in FIG. 4 can be replaced with the LTPS TFT-LCD panel 3000.

FIG. 5 is a schematic diagram illustrating an electronic device incorporating the LTPS TFT-LCD device 4 shown in FIG. 4. An input device 5 is coupled to the controller 3 of the LTPS TFT-LCD device 4 shown in FIG. 4 to form an electronic device 6. The input device 5 can include a processor or the like to input data to the controller 3 to render an image. The electronic device 6 may be a portable device such as a PDA, notebook computer, tablet computer, cellular phone, or a display monitor device, or non-portable device such as a desktop computer.

According to the described embodiments of the invention, the extended portion of the third insulating layer is employed to construct the second storage capacitor overlying the first storage capacitor without occupying additional pixel area, thus, the storage capacitance is increased without affecting the aperture ratio. Specifically, the first portion and the extended portion of the third insulating layer are formed concurrently, thus, reducing the process complexity and cost.

## Claims

1. A stacked storage capacitor structure for a LTPS (low temperature polysilicon) TFT-LCD, comprising:
a substrate (204; 304);
a first storage capacitor (Cst, 22; 32) comprising a first conductive layer (21, 312), a second conductive layer (220; 320) and a first insulating layer (216; 316) therebetween, wherein the second conductive layer is disposed over the first conductive layer, and wherein the first storage capacitor is disposed over the substrate;
a third conductive layer comprising a first portion (232a; 323a) and an extended second portion (232b; 323b); and
a second storage capacitor (Cst', 29; 39) comprising the second conductive layer (220; 320), the extended second portion (232b; 323b) of the third conductive layer and a second insulating layer (224a; 324a) therebetween, wherein
the extended second portion (232b; 323b) of the third conductive layer is disposed over the second conductive layer (220; 320),
the second storage capacitor (Cst', 29; 39) is disposed over the first storage capacitor (Cst, 22; 32) , and is electrically connected thereto,
a third portion of the third conductive layer is directly in contact with a fourth portion of the second insulating layer (224a; 324a), and
the fourth portion of the second insulating layer (224a; 324a) has a relative thickness less than that of the other portion of the second insulating layer
**characterized in that** the second insulating layer (224; 324) comprises silicon nitride.

2. The stacked storage capacitor structure for a LTPS TFT-LCD according to claim 1, further comprising a passivation layer (236; 336) with a via (246; 346) therein and a pixel electrode (240; 340) overlying the passivation layer, wherein the pixel electrode is electrically connected to the first portion (232a; 323a) of the third conductive layer through the via (246; 346).

3. The stacked storage capacitor structure for a LTPS TFT-LCD according to claim 1 or 2, further comprising a third insulating layer (228a; 328a) between the second insulating layer (224a; 324a) and the extended second portion (232b; 323b) of the third conductive layer, wherein the third insulating layer (228a) and the second insulating layer (224a) has a recessed portion.

4. The stacked storage capacitor structure for a LTPS TFT-LCD according to any of the preceding claims, wherein the fourth portion of the second insulating layer (224a; 324a) has a thickness between 800 and 1200 A.

5. The stacked storage capacitor structure for a LTPS TFT-LCD according to any of the preceding claims, wherein the substrate comprises a substrate (204; 304) and a buffer layer (208; 308) thereon.

6. The stacked storage capacitor structure for a LTPS TFT-LCD according to any of the preceding claims, wherein the first portion (232a; 323a) of the third conductive layer is electrically connected to the first conductive layer (212; 312) through the third insulating layer (228a; 328a), the second insulating layer (224a; 324a) and the first insulating layer (216; 316).

7. A LTPS TFT-LCD panel (2000; 3000), comprising:
a stacked storage capacitor structure for a LTPS TFT-LCD as claimed in any of the preceding claims;
a color filter substrate (252; 352) opposite a TFT array substrate (200; 300); and
a liquid crystal layer (250; 350) between the TFT array substrate and the color filter substrate.

8. A LTPS TFT-LCD device, comprising:
the LTPS TFT-LCD panel (2000; 3000) as claimed in claim 7; and
a controller (3) coupled to the LTPS TFT-LCD panel, controlling the panel to render images in accordance with input.

9. An electronic device (6), comprising:
the LTPS TFT-LCD device as claimed in claim 8;
an input device (5) coupled to the controller (3) of the LTPS TFT-LCD device, controlling the display device to render images.

## Patentansprüche

1. Stapel-Speicherkondensatoranordnung für einen LTPS (Niedrigtemperatur-Polysilizium) TFT-LCD, umfassend:
ein Substrat (242; 304);
einen ersten Speicherkondensator (Cst, 22; 32) mit einer ersten leitenden Schicht (21, 312), einer zweiten leitenden Schicht (220; 320) und einer ersten Isolierungsschicht (216; 316) zwischen diesen Schichten, wobei die zweite leitende Schicht über der ersten leitenden Schicht angeordnet ist und wobei der erste Speicherkondensator über dem Substrat angeordnet ist;
eine dritte leitende Schicht mit einem ersten Abschnitt (232a; 323a) und einem erweiterten zweiten Abschnitt (232b; 323b); und
einem zweiten Speicherkondensator (Cst', 29; 39) mit der zweiten leitenden Schicht (220; 320), dem erweiterten zweiten Abschnitt (232b; 323b) der dritten leitenden Schicht und einer zweiten Isolierungsschicht (224; 324a) zwischen diesen Schichten, wobei
der zweite erweiterte Abschnitt (232b; 323b) der dritten leitenden Schicht über der zweiten leitenden Schicht (220; 320) angeordnet ist,
der zweite Speicherkondensator (Cst', 29; 39) über dem ersten Speicherkondensator (Cst, 22; 32) angeordnet ist und mit diesem elektrisch leitend verbunden ist,
der dritte Speicherkondensator (Cst', 29; 39) über dem ersten Speicherkondensator (Cst, 22; 32) angeordnet ist und mit diesem elektrisch leitend verbunden ist,
ein dritte Abschnitt der dritten leitenden Schicht unmittelbar mit einem vierten Abschnitt der zweiten Isolierungsschicht (224a; 324a) in Kontakt steht, und
der vierte Abschnitt der zweiten Isolierungsschicht (224a; 324a) eine relative Dicke aufweist, die kleiner ist als die des übrigen Abschnittes der zweiten Isolierungsschicht,
**dadurch gekennzeichnet, dass** die zweite Isolierungsschicht (224; 324) Siliziumnitrid aufweist.

2. Stapel-Speicherkondensatoranordnung für einen LTPS TFT-LCD nach Anspruch 1, weiterhin umfassend eine Passivierungsschicht (236; 336) mit einem Kontaktloch (246; 346) darin und einer Pixelelektrode (240; 340) über der Passivierungsschicht, wobei die Pixelelektrode über das Kontaktloch (246; 346) elektrisch leitend mit dem ersten Abschnitt (232a; 323a) der dritten leitenden Schicht verbunden ist.

3. Stapel-Speicherkondensatoranordnung für einen LTPS TFT-LCD nach Anspruch 1 oder 2, weiterhin umfassend eine dritte Isolierungsschicht (228a; 328a) zwischen der zweiten Isolierungsschicht (224a; 324a) und dem erweiterten zweiten Abschnitt (232b; 323b) der dritten leitenden Schicht, wobei die dritte leitende Schicht (228a) und die zweite leitende Schicht (224a) eine Aussparung aufweisen.

4. Stapel-Speicherkondensatoranordnung für einen LTPS TFT-LCD nach einem der vorhergehenden Ansprüche, wobei der vierte Abschnitt der zweiten Isolierungsschicht (224a; 324a) eine Dicke zwischen 800 und 1200 Å aufweist.

5. Stapel-Speicherkondensatoranordnung für einen LTPS TFT-LCD nach einem der vorhergehenden Ansprüche, wobei das Substrat eine Substrat (204; 304) und eine darauf ausgebildete Puffer- bzw. Übergangsschicht (208; 308) aufweist.

6. Stapel-Speicherkondensatoranordnung für einen LTPS TFT-LCD nach einem der vorhergehenden Ansprüche, wobei der erste Abschnitt (232a; 323a) der dritten leitenden Schicht über die dritte Isolierungsschicht (228a; 328a) elektrisch leitend mit der ersten Isolierungsschicht (216; 316) verbunden ist.

7. Ein LTPS TFT-LCD-Display (2000; 3000), umfassend:
eine Stapel-Speicherkondensatoranordnung für einen LTPS TFT-LCD nach einem der vorhergehenden Ansprüche;
ein Farbfiltersubstrat (252; 352), das einem TFT-Arraysubstrat (200; 300) gegenüberliegt; und
eine Flüssigkristallschicht (250; 350) zwischen dem TFT-Arraysubstrat und dem Farbfiltersubstrat.

8. Eine LTPS TFT-LCD-Einrichtung, umfassend
den LTPS TFT-LCD-Display (2000; 3000) nach Anspruch 7; und
einen Controller (3), der mit dem LTPS TFT-LCD-Display verbunden ist und den Display steuert, um Bilder in Entsprechung zu einem Eingangssignal darzustellen.

9. Elektronische Einrichtung (6), umfassend:
die LTPS TFT-LCD-Einrichtung nach Anspruch 8;
eine Eingabeeinrichtung (5), die mit dem Controller (3) der LTPS TFT-LCD-Einrichtung verbunden ist, um die Displayeinrichtung zur Darstellung von Bildern zu steuern.

## Revendications

1. Une structure de condensateurs de stockage empilés pour un LTPS (polysilicium à faible température) TFT-LCD, comprenant:
un substrat (204, 304);
un premier condensateur de stockage (Cst, 22; 32) comprenant une première couche conductrice (21, 312), une seconde couche conductrice (220; 320) et une première couche d'isolation (216; 316) intermédiaire, dans laquelle la seconde couche conductrice est disposée sur la première couche conductrice, et dans laquelle le premier condensateur de stockage est disposé sur le substrat;
une troisième couche conductrice comprenant une première partie (232a; 223a) et une seconde partie étendue (232b; 323b); et
un second condensateur de stockage (Cst', 29; 39) comprenant la seconde couche conductrice (220; 320), la seconde partie étendue (232b; 323b) de la troisième couche conductrice et une seconde couche d'isolation (224a; 324a) intermédiaire, dans laquelle
la seconde partie étendue (232b; 323b) de la troisième couche conductrice est disposée sur la seconde couche conductrice (220; 320),
le second condensateur de stockage (Cst', 29; 39) est disposé sur le premier condensateur de stockage (Cst, 22; 32), et y est électriquement raccordé;
une troisième partie de la troisième couche conductrice est directement en contact avec une quatrième partie de la seconde couche d'isolation (224a; 324a), et
la quatrième partie de la seconde couche d'isolation (224a; 324a) présente une épaisseur relative inférieure à celle de l'autre partie de la seconde couche d'isolation
**caractérisée en ce que** la seconde couche d'isolation (224; 324) comporte du nitrure de silicium.

2. La structure de condensateurs de stockage empilés pour un LTPS TFT-LCD selon la revendication 1, comprenant en outre une couche de passivation (236; 336) avec un via (246; 346) en son sein et une électrode de pixel (240; 340) recouvrant la couche de passivation, dans laquelle l'électrode de pixel est connectée électriquement à la première partie (232a; 323a) de la troisième couche conductrice au travers le via (246; 346).

3. La structure de condensateurs de stockage empilés pour un LTPS TFT-LCD selon la revendication 1 ou 2, comprenant en outre une troisième couche d'isolation (228a; 328a) entre la seconde couche d'isolation (224a; 324a) et la seconde partie étendue (232b; 323b) de la troisième couche conductrice, dans laquelle la troisième couche d'isolation (228a) et la seconde couche d'isolation (224a) comportent une partie encastrée.

4. La structure de condensateurs de stockage empilés pour un LTPS TFT-LCD selon l'une quelconque des revendications précédentes, dans laquelle la quatrième partie de la seconde couche d'isolation (224a; 324a) présente une épaisseur comprise entre 800 et 1200 Angströms.

5. La structure de condensateurs de stockage empilés pour un LTPS TFT-LCD selon l'une quelconque des revendications précédentes, dans laquelle le substrat comporte un substrat (204; 304) et une couche tampon (208; 308) au dessus.

6. La structure de condensateurs de stockage empilés pour un LTPS TFT-LCD selon l'une quelconque des revendications précédentes, dans laquelle la première partie (232a; 323a) de la troisième couche conductrice est électriquement connectée à la première couche conductrice (212, 312) au travers la troisième couche d'isolation (228a, 328a), la seconde couche d'isolation (224a; 324a) et la première couche d'isolation (216; 316).

7. Un panneau LTPS TFT-LCD (2000; 3000), comprenant :
une structure de condensateurs de stockage empilés pour un LTPS TFT-LCD selon l'une quelconque des revendications précédentes;
un substrat de filtre couleur (252; 352) opposé à un substrat d'aire TFT (200; 300); et
une couche de cristal liquide (250; 350) entre le substrat d'aire TFT et le substrat de filtre couleur.

8. Un dispositif LTPS TFT-LCD, comprenant :
le panneau LTPS TFT-LCD (2000; 3000) tel que revendiqué dans la revendication 7; et
un contrôleur (3) couplé au panneau LTPS TFT-LCD (2000; 3000), commandant le panneau pour générer des images en fonction des entrées.

9. Un dispositif électronique (6), comprenant:
le dispositif LTPS TFT-LCD tel que revendiqué dans la revendication 8; et
un dispositif d'entrée (5) couplé au contrôleur (3) du dispositif LTPS TFT-LCD, commandant l'affichage des images par le dispositif d'affichage.
